# EUROPEAN PATENT SPECIFICATION

(11) **EP 3 232 675 B1**
(45) Date of publication and mention of the grant of the patent: **03.08.2022**
(21) Application number: 17160893.8
(22) Date of filing: 14.03.2017
(51) Int. Cl.: H04N 21/41, H04N 5/76, G11B 5/455, G06F 11/34, H04N 5/907

(54) **METHOD FOR TESTING PERFORMANCE OF A STORAGE DEVICE AND AND CORRESPONDING DEVICE**
VERFAHREN ZUR PRÜFUNG DER LEISTUNG EINER SPEICHERVORRICHTUNG UND ENTSPRECHENDE VORRICHTUNG
PROCÉDÉ POUR TESTER LA PERFORMANCE D'UN DISPOSITIF DE STOCKAGE ET DISPOSITIF CORRESPONDANT

(30) Priority: 21.03.2016 EP 16305307
(43) Date of publication of application: 18.10.2017
(73) Proprietor: InterDigital Madison Patent Holdings, SAS, 75017 Paris (FR)
(72) Inventor: RIGAL, Renaud, 35576 Cesson-Sévigné Cedex (FR); SEINGIER, François-Xavier, 35576 Cesson-Sévigné Cedex (FR); QUERE, Thierry, 35576 Cesson-Sévigné Cedex (FR)
(74) Representative: Interdigital

(56) References cited:
- EP-A2- 1 534 005
- KR-A- 20060 081 931
- US-A1- 2007 255 518
- US-A1- 2008 310 825
- US-B1- 7 054 790

## Description

### FIELD

The present disclosure generally relates to the field of performance testing of storage devices.

### BACKGROUND

Digital video recording (DVR) and Personal Video Recording (PVR) functions are proposed by many audio/video consumer devices. DVR/PVR functions allow a user to record, to playback, and to pause a broadcasted audio/video stream. DVR/PVR functions are proposed on television sets, set top boxes (STB), mobile devices, and personal computers. For reasons of economy and footprint, these devices are commonly not supplied with a storage device required to enable use of the DVR/PVR functions. It is up to the consumer to supply an external storage apparatus and to connect it to a data communication port of the audio/video device. Examples of commonly commercialized storage devices are Universal Serial Bus (USB) Hard Disk Drives (HDD) and memory sticks. Storage devices come in various prices and different quality. Personal computers (PCs) generally have sufficient internal hard disk space for providing a DVR/PVR function. However, the performance of DVR/PVR read-write operations can be degraded by other tasks that are simultaneously executed by the PC and that also make use of the internal storage device, and which are not under control of the audio/video application.

If the performance of a storage device used for DVR/PVR functionality is insufficient, the DVR/PVR function will be adversely affected, resulting in visible and audible artefacts such as macroblocks and audio/video glitches. Consumers may mistakenly conclude that the audio/video device is defective, resulting in a considerable workload for helpdesk and after-sales services.

There is thus a need for performance testing of storage devices.

Document US-A-2007/255518 describes a system and method for testing performance of a disk drive in a digital home communications terminal.

Document US-B-7054790 describes a method for measuring performance of a storage device including rotatable media.

### SUMMARY

The present disclosure aims at alleviating at least some of the deficiencies discussed in the background section. The invention is defined by the appended claims.

### BRIEF DESCRIPTION OF THE DRAWINGS

More advantages of the present disclosure will appear through the description of particular, non-restricting embodiments. In order to describe the manner in which the advantages of the present disclosure can be obtained, particular descriptions of the present principles are rendered by reference to specific embodiments thereof which are illustrated in the appended drawings. The drawings depict exemplary embodiments of the disclosure and are therefore not to be considered as limiting its scope. The embodiments described can be combined to form particular advantageous embodiments. In the following figures, items with same reference numbers as items already described in a previous figure will not be described again to avoid unnecessary obscuring the disclosure. The exemplary embodiments will be described with reference to the following figures:
**Figure 1** illustrates an exemplary environment enabling DVR/PVR functions of an audio/video receiver.
**Figure 2** is a schematic view of an exemplary embodiment of the Set-Top Box illustrated in figure 1.
**Figure 3** further illustrates the present principles of evaluating performance of a storage device through binary read-write testing.
**Figure 4** is a flow chart according to a particular embodiment of the present principles.

### DETAILED DESCRIPTION

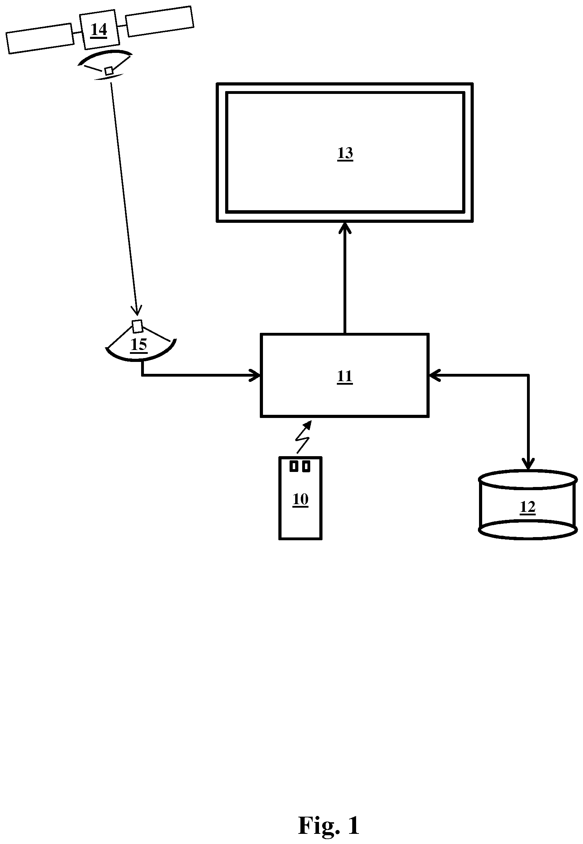

**Figure 1** illustrates an exemplary environment enabling DVR/PVR functions of an audio/video receiver **11.** Audio/video receiver device **11** is a Set-Top Box (STB) for reception of audio/video streams from a satellite **14,** as is well known in the art. The audio/video streams are received from satellite **14** and reception antenna **15.** The STB **11** transmits an audio/video signal to a digital television **13** for rendering. Connected to STB **11** is a storage device **12.** STB **11** is operated through a remote control (RC) **10.**

As briefly discussed in the background section, the audio/video receiver **11** comprises a data communication port (not shown) for connecting the storage device **12.** While the audio/video receiver **11** comprises DVR/PVR functions, it requires the presence of storage device **12** to propose the DVR/PVR functions to the consumer. A storage device is generally not supplied with the audio/video receiver **11** but is to be supplied by the consumer. Consumers have a wide choice of storage device types, models and make. For example, the consumer may provide a USB memory stick. USB memory sticks comply with various standards (e.g., USB 1.0, 2.0 or 3.0) and come in various qualities. It has been found that while USB memory sticks electrically do comply with a given standard, the maximum data transfer rate is sometimes way lower than could have been expected according to the standard it is supposed to comply with. Unlike for USB memory sticks, a speed class rating is defined for storage devices of the SD card type. However, even if it is indicated in a user manual that for good performance of DVR/PVR operations an SD card is to be used with a speed class rating equal or higher than a given value, it cannot be guaranteed that consumers respect this.

It is therefore useful to evaluate the performance of a storage device before starting to use it for DVR/PVR functions in order to avoid malfunctioning of the DVR/PVR functions.

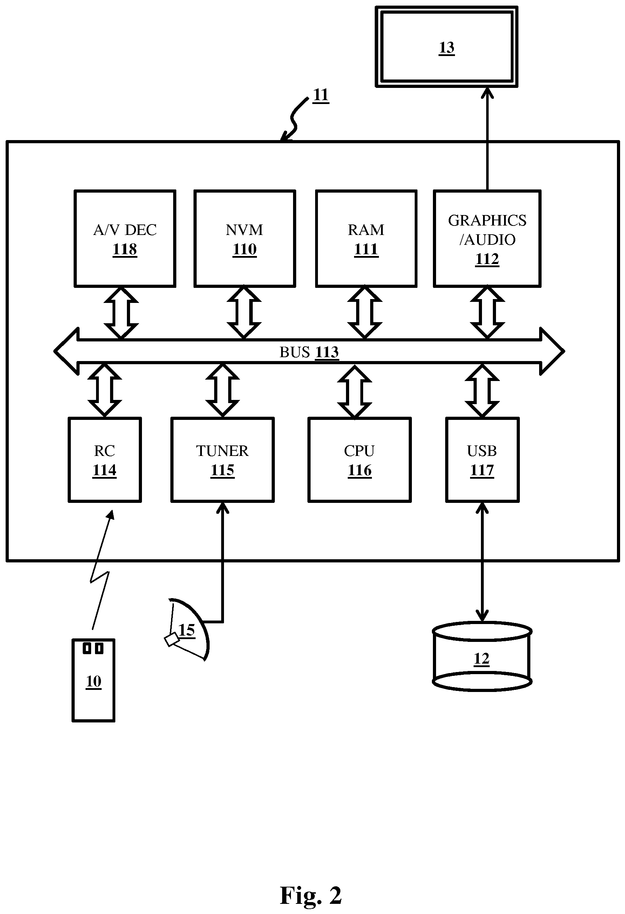

**Figure 2** is a schematic view of an exemplary embodiment of the Set-Top Box illustrated in figure 1. STB **11** comprises: a non-volatile memory (NVM) **110,** a random access memory (RAM) **111,** a graphics and audio controller **112,** a remote control circuit **114,** a tuner **115,** a central processing unit (CPU) **116,** an audio/video decoder (A/V DEC) **118,** and a peripheral interface **117,** e.g., according to the universal serial bus (USB), High Definition Multimedia Interface (HDMI), Ethernet, WiFi, Bluetooth, or Serial ATA (SATA), to name some. All these components are interconnected by means of an internal data and communication bus **113.** Remote control circuit **114** is configured to receive remote control commands from remote controller **10.** Tuner **115** is configured to receive audio/video streams from satellite antenna **15.** Peripheral interface **117** is configured to be connected to storage device **12.** Graphics controller **112** is configured to be connected to display **13** for rendering of audio/video. STB memory comprises NVM **110** and RAM **111.** NVM **110** comprises for example a set of computer-readable program instructions that are executable by CPU **116** and that comprise the program for implementing functions of device **11.** For example, the set of program instructions comprise firmware, middleware and application programs. NVM **110** may also comprise parameters and variables used for operating STB **11,** such as a channel list, user preferences, and internal parameters and variables used for the program instructions. RAM **111** is used for temporary storage of program instructions, variables and parameters. Graphics and audio card **112** is configured to drive audio/video rendering device **13.** Audio/video decoder **118** is configured to decode audio/video streams.

During operation of STB **11,** a user selects an audio/video channel to tune to using remote control **10.** A corresponding instruction is sent to CPU **116,** which retrieves a channel list from NVM **110,** extracts associated tuning parameters from the channel list, and instructs tuner **115** to tune to a frequency indicated by the extracted tuning parameters. The tuner **115** then receives an audio/video stream broadcasted on the given frequency and transfers the received audio/video stream to audio/video decoder **118.** The audio/video decoder **118** transfers decoded audio/video to graphics/audio controller **112,** which outputs audio/video to rendering device **13.** When the user presses a pause button on remote control **10 to** pause the broadcast channel received, STB **11** stores the audio/video stream received from tuner **115** on storage device **12.** When the user then resumes playing, STB **11** transfers the stored audio/video stream to audio/video decoder **118** and decoded audio/video is rendered on rendering device **13.** During this time, STB **11** continues to store the audio/video broadcast stream received from tuner **115** on storage device **12.** In this configuration, storage device **12** is used as a buffer memory for a time shift operation. It can thus be seen that the time shift requires simultaneous read and write operation on storage device **12.** The read-write performance of storage device **12** should be sufficient to support the resulting high data communication rate and frequent alternation of read-write operations if the time shift feature is to function correctly.

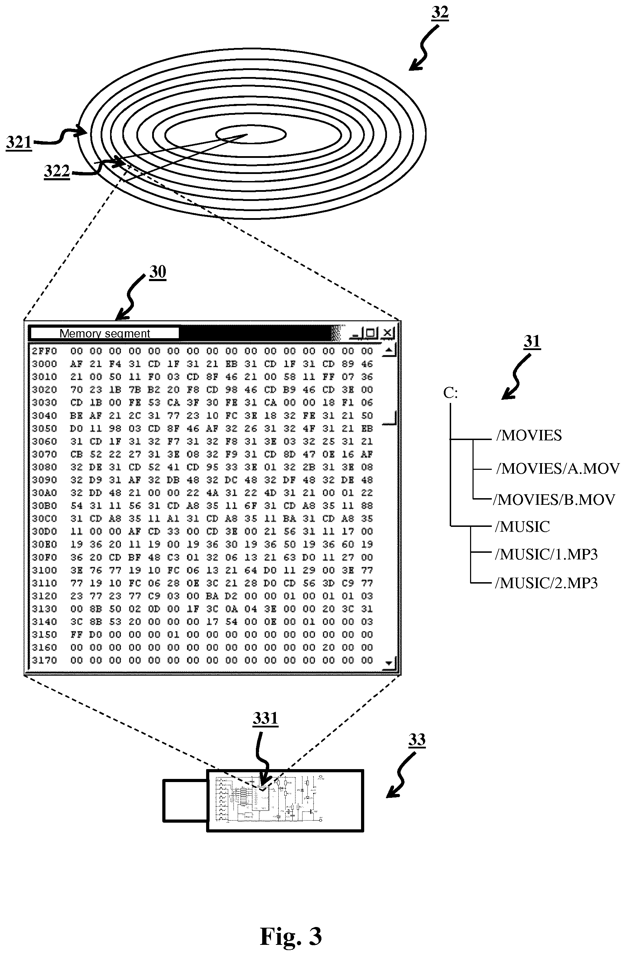

**Figure 3** further illustrates the present principles of evaluating performance of a storage device through binary read-write testing. Element **30** is a memory segment of a storage device used for providing DVR/PVR functions. Element **32** is a hard disk of a hard disk drive. Element **33** is a memory stick. Element **31** is a file system with directories, subdirectories and files, that is for example stored by devices **32** and **33.** Elements **32** and **33** are illustrated as alternative implementations of storage devices. Other embodiments not illustrated can be used for the purpose of the present principles, such as an SD card or any kind of Solid State memory, such as a solid state disk (SSD). Typical of the hard disk **32** is an organization in concentric tracks **321** and sectors **322.** Typical of the memory stick is the presence of a non-volatile RAM memory **331.** Broken lines indicate where on the devices **32** and **33** the memory segment **30** is stored: in a sector **322** on hard disk **32,** and in a memory chip **331** on memory stick **33.** Read-write performance of the storage devices **32** and **33** can be tested by a host device, e.g., STB **11** of figures 1 or 2. For this purpose, a binary memory segment **30** is read from a start address x (e.g., 0x2FF0 as illustrated) on the storage device for a length *n* (e.g., 0x1000), e.g., from storage device **32** or **33,** and saved via the host device **11** to storage space available to the host device **11** other than the storage device (e.g., to NVM **110,** to a network storage space, or to a cloud storage space). 'Binary memory segment' means here that the memory segment is not read using the file system organization of device **32** or **33,** but directly at driver level as raw data. Start address x and segment length *n* can be determined according to various parameters. Unplugging of the storage device while read-write tests are ongoing may result in data being corrupted on the storage device. The data corruption may be more or less severe. Preferably, the start address x and length *n* are chosen such that the memory segment does not fall within a File Allocation Table (FAT), Master Boot Record (MBR) or GUID Partition Table (GPT) zone, since an ongoing read-write test in this zone that is interrupted due to unplugging of the storage device may cause a complete data loss if the original contents of the data segment, as stored on the host device, is not restored on the storage device. Different embodiments discussed further and propose solutions for data recovery in a case where an ongoing read-write test is interrupted. Many storage devices also keep a backup copy of the FAT/MBR/GPT at the end of the storage space of the storage device. Preferably, the main and the backup FAT/MBR/GTP zones are thus avoided for executing binary read-write tests. For example, if a storage device is of size *m*, it is safe to use as a start address *m*/*2* - *n*/2, wherein *n* is the length of the segment starting at *m*/2 and is chosen as a fraction of *m*, for example 1/5^{th}, 1/10^{th} or 1/20^{th} of *m*, in order to stay out of the FAT/MBR/GPT zones. The length of the segment has an influence on the duration of the performance evaluation, notably because the performance evaluation comprises copying of the read-write test segment to the host device (=backup), and rewriting the copied read-write test segment saved on the host, from the host to the storage device at the end of the read-write testing (=restore) as will be further discussed. The delay caused by the backup and restore operations, in addition to the rules defined above that help to exclude performing read-write tests in the FAT/MBR/GPT zones, can thus be considered to define the length of the segment. Preferably, the length of the segment is chosen such that the performance evaluation can be done in a short time, for example, in 15, 30, 60 or 120 seconds, to avoid penalizing a user that plugs in a storage device because he/she is watching a tv program that he/she wants to record or that he/she wants to pause.

When the storage device is connected, the device driver attributes a physical name to the storage device, e.g., /dev/sda, or /dev/sda1 and /dev/sda2 if the device has two partitions. Binary read (and write) operations can be done directly from (to) these partitions that are mounted on the host device. For example, the binary segment may span over several files when memory segment start address x corresponds to somewhere in one file and the memory segment end address corresponds to somewhere in another file stored on the storage device.

Then a read-write operations performance test of the storage device **32** or **33** is executed by the host device on the memory segment in the storage device **32** or **33** that corresponds to binary segment **30.** For this purpose, binary read-write tests are executed. 'Binary' in this context means, that the read-write operations are executed on a low abstraction level; for example, at driver level. When the read-write performance testing is completed, the copy of the memory segment on the storage device used for the performance test is retrieved (backed up) from storage space available to the host device (other than the storage device) and is restored to the storage device by a binary write operation to the memory segment on the storage device at its original place. This way, the memory contents of the storage device are restored to its original state, i.e., the state it had before execution of the binary read-write tests. The binary read-write performance is tested through a set of binary read-write operations and evaluating time required to complete these operations. The set may comprise one, two, ten, hundred or thousand or more read-write operations.

According to a different embodiment, the binary read-write tests comprise the determining of a read-write bit rate. For example, a minimum, a maximum or a mean bit rate is determined. For example, to determine a mean bit rate, a delay is defined in which repetitive read-write tests are done. When the delay expires, the number of completed read-write test iterations is totalized. The amount of data read-written and the number of completed iterations then allow to determine the mean read-write bit rate. For example, to determine a maximum read-write bit rate, a delay is defined in which repetitive read-write tests are done. When the delay expires the maximum read-write bit rate is then obtained by dividing the amount of data read-written in each iteration of the completed read-write tests by the time needed to complete the iteration, comparing the results for all completed iterations and selecting the highest read-write bit rate. For example, to determine a minimum read-write bit rate, the results for all completed iterations are compared and the lowest bit rate is selected. Determining the minimum and maximum bit rate in addition to the determining the mean bit rate is advantageous for determining a precise profile of the storage device. For example, while a storage device has a mean bit rate that is sufficient for providing DVR/PVR functions, the minimum bit rate is lower than a minimum threshold bit rate, in which case the minimum bit rate rather than the mean bit rate is a good indicator for determining the performance profile of the storage device. Performance profiles are handled further on. For example, while mean and minimum read-write bit rates are sufficient for supporting DVR/PVR functions, the variance between minimum and maximum read-write bit rates may exceed a tolerance, in which case the storage device may be considered as too unreliable for providing DVR/PVR functions.

According to a different embodiment that can advantageously combined with the previous embodiments, the binary read-write tests comprises determining of a maximum number of simultaneous read-write operations.

As mentioned above, a performance profile is established according to the result of the binary read-write tests. The performance profile indicates for which use the storage device is suited for. For example, a performance profile indicates that the storage device is suited (has sufficient performance capabilities) for storing and playback of Standard Definition (SD), High Definition (HD) or Ultra-High Definition (UHD) type content through a classification in a maximum supported video resolution class, or in other words, the performance profile indicates that the storage device has sufficient performance capabilities to be used as a device for storing and retrieving video data with a video resolution corresponding to the performance profile. The performance profile may also indicate that the storage device is suited for storage and playback of content having one or more video profiles of a specific encoding standard such as baseline profile, main profile, high profile such as defined for MPEG2 or H.264 encoded video. The performance profile may also indicate that the storage device is suited for storage and playback, for example, of one or more video resolutions associated to one or more standards. For example, a performance profile may indicate that a storage device is suited for storage and playback of SD encoded video; for SD and HD encoded video; for MPEG2 SD encoded video; for H.264 HD encoded video; for MPEG2 SD and H.264 HD encoded video; for MPEG2 HD high profile and H.264 UHD main profile encoded video.

The performance profile may also indicate through a classification in a multiple recording class that the storage device is suitable for simultaneous recording of multiple audio/video streams. The simultaneous recording of multiple audio/video streams may for example allow to record streams from several TV channels simultaneously, or for example to record one TV channel while time shifting another TV channel. For example, the performance profile indicates through a classification in a time shift class that the storage device is suitable for simultaneous recording of an audio/video stream and playback of the recorded audio/video stream for time shift purposes, while a classification in a single recording class indicates that the storage device is suited for non-simultaneous single recording and single playback not including time shift. For example, the performance profile indicates through a classification a UHD class that the storage device is suitable for UHD recording and playback, while it is suited for HD time shift and thus for SD time shift, but excluding UHD time shift. For example, the performance profile may indicate that the storage device is suited for UHD time shift, and thus for HD and SD time shift. According to a particular embodiment, the classification can be operated according to previous mentioned thresholds of mean, minimum and/or maximum bit rate. The table hereunder gives a simple and straight forward example of performance profiles based on mean read-write bit rate thresholds. It does for example not take in to account the previous discussed measuring of minimum and maximum read-write bit rates nor does it for example take into account a differentiation of support for according to maximum supported video resolution class.

| **Examples of mean read-write bit rate thresholds** | **Performance profile** |
|---|---|
| < 10Mbit/s | Low bit rate data storage only (e.g., file download). |
| 10-15Mbit/s | Recording |
| >15Mbit/s | time shift (=recording or time shift) |
| > 30Mbit/s | recording and time shift |

Bit rates of audio/video streams may vary according to encoding type, scene, and encoding quality. For example, the highest bit rate of a variable bit rate MPEG-2 encoded SD stream of a football match may approach a highest bit rate of a variable bit rate HEVC encoded HD stream of the same. According to a different embodiment, the thresholds are determined according to the bit rates of the streams that the host audio/video receiver device is to receive, for example according to the highest bit rate that can be expected for streams in the subscripted channels.

Among advantages of the binary operation of the read-write testing according to the present principles are that the binary read-write tests are independent of the file system type, partitioning or formatting used on the storage device, which enables evaluating a performance profile of unformatted storage devices or storage devices comprising a file system that is not supported by the host, or of storage devices comprising encrypted files. Thus, advantageously, the performance profiling according to the present principles allow to determine if, in terms of read-write operation rate, a storage device is suitable for being used with the host device to implement DVR/PVR features. For example, a host device that only supports the Linux file system "ext", can execute a performance profiling evaluation on a storage device formatted according to a HFS file system of Apple Inc. Then, if the result of the performance test is satisfying, the host may inform a user that the performance test was successful, that the storage device may be used as a storage device for providing DVR/PVR functions, and may ask the user if he/she agrees with reformatting the storage device with a file system compatible with that used by the host. The reformatting is for example only proposed if the outcome of the performance evaluation is that the storage device is suited for DVR/PVR use with the host device.

According to a different embodiment, the performance profile is stored on the host device. According to a different embodiment, the performance profile is related to an identification of the storage device or to a type of storage device, e.g., comprising the model and make of the storage device. According to a different embodiment this relation is stored on the host device. Then, when the storage device is removed and replaced by another of a same type or of a same model and make, it can be determined from the stored performance profiles that a stored performance profile already exists for the device and that it is not necessary to perform the performance test again. Multiple performance profiles can be stored, for example in a table of a database. According to a different embodiment, the performance profile is stored on the storage device. According to a different embodiment, the performance profile is stored in a storage space in a network to which the host device is connected. Then, if a storage device is connected to a host device, the host device interrogates the network to find out if a performance profile exists for the model and make of storage device. If so, it is not necessary to retest the storage device and the results of the performance test stored in the network can be retrieved by the host device. Advantageously, host devices thus share a common knowledge base using a network storage space for storing performance profiles of storage devices, so that a performance profile, once established by any of a plurality of host devices, can be retrieved by any of the plurality of host devices later on, thereby avoiding that for a same model and make of storage device multiple performance evaluations are done.

According to a different embodiment, a protection is provided against unplugging of the storage device when the binary read-write testing is ongoing, as this can cause a data corruption on the storage device as has been discussed above. To this end, when the storage device is unplugged during binary read-write testing, the host device detects the unplugging and generates an audible and/or visible message to incite the user to re-plug the storage device to avoid data corruption on the storage device. According to a different embodiment, when the storage device is re-plugged, it is verified that the segment used for the read-write tests is in the same state as it was before the unplugging. If it is in the same state, the read-write tests can continue; if not, the storage device has been used in between or a different storage device has been plugged instead. The read-write tests are aborted and the data saved (backed up) via the host device are not restored to the segment of the storage device to avoid overwriting of data on the storage device.

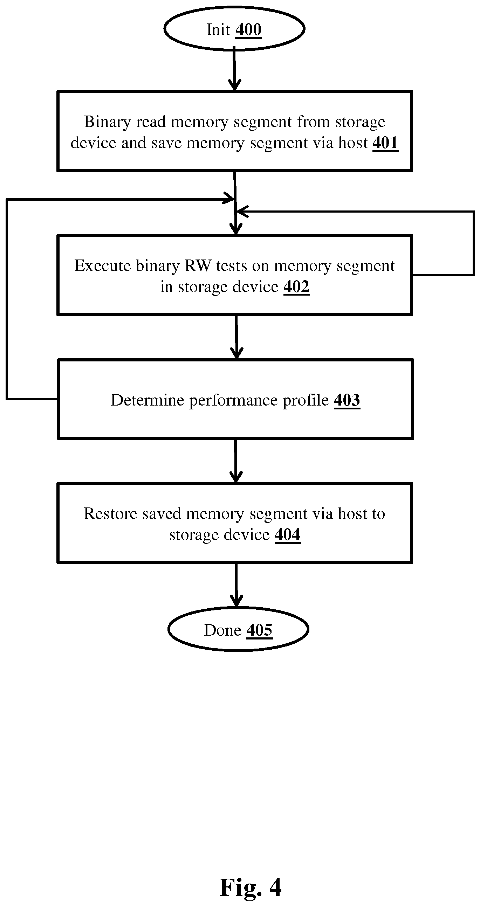

**Figure 4** is a flow chart according to a particular embodiment of a method according to the present principles, as implemented by a host device, such as device **11** of figure 2. Step **400** is an initialization step in which variables used during the execution of the steps are initialized. In a step **401,** a memory segment is read from a storage device from a memory start address, or in other words copied, saved, backed up or cached via the host device, that is, e.g., in a memory of the host device itself, e.g., in a non-volatile memory, or in a network storage attached to the host device or in a cloud storage available to the host device via a network connection. The storage device is for example storage device **12** depicted in figure 2. In a step **402,** one or more binary read-write tests are executed on the memory segment in the storage device. In a step **403,** a performance profile is determined for the storage device according to a result of the binary read-write tests executed in step **402.** For establishing the performance profile, binary read-write test step **402** may be iterated, for example for executing iterations of binary read-write tests that allow to determine a mean, a minimum or a maximum read-write bit rate, or that allow to determine a maximum number of simultaneously executable read-write operations. Then, in a step **404,** after having determined the performance profile in step **403,** the memory segment cached via the host device is rewritten or restored to the host device to the memory start address, thereby restoring the storage device to its original state; that is, the state it had before executing the binary read-write tests. The method ends with step **405.** The storage device can now be used for DVR/PVR functions provided the outcome of the performance profiling is that the storage device enables these functions, be used for data storage only (e.g., for file download) if the performance profile is insufficient for providing DVR/PVR functions, or be unplugged and reused for other purposes. A message may be shown to the user indicating the performance profile as evaluated for the storage device. If the performance profile is sufficient for use of the storage device for DVR/PVR functions for example, the message may ask the user if any data present on the storage device may be overwritten, or may propose the opportunity for the user to unplug the storage device, backup the data present on the storage device, and re-plug the storage device.

As will be appreciated by one skilled in the art, some elements in the drawings may not be used or be necessary in all embodiments. Some operations may be executed in parallel. Different embodiments other than those illustrated and/or described are possible. For example, while in figures 1-2 the storage device is directly connected to the host device, the skilled in the art will appreciate that the storage device can also be a network storage device, for example connected to a Local Area Network, without diverting from the present principles. For example, the skilled person will readily understand that the storage device **12,** depicted in figures 1-2 as being external to host device **11,** can also be internal to the host device without departing from the present principles. Likewise, the host device, depicted in figures 1-2 as a set top box, can be another type of device, such as an access gateway, a digital television, or a smart phone, not necessarily receiving audio/video streams from satellite, but from cable, via Internet, 4G, or any other type of data transmission medium.

As will be appreciated by one skilled in the art, aspects of the present principles can be embodied as a system, method or computer program instructions for storing on a computer readable medium. Accordingly, aspects of the present principles can take the form of an entirely hardware embodiment, an entirely software embodiment (including firmware, resident software, micro-code and so forth), or an embodiment combining hardware and software aspects that can all generally be defined to herein as a "circuit", "module" or "system". Furthermore, aspects of the present principles can take the form of a computer readable storage medium. Any combination of one or more computer readable storage medium(s) can be utilized.

Thus, for example, it will be appreciated by those skilled in the art that the diagrams presented herein represent conceptual views of illustrative system components and/or circuitry embodying the principles of the present disclosure. Similarly, it will be appreciated that any flow charts, flow diagrams, state transition diagrams, pseudo code, and the like represent various processes which may be substantially represented in computer readable storage media and so executed by a computer or processor, whether or not such computer or processor is explicitly shown.

A computer readable storage medium can take the form of a computer readable program product embodied in one or more computer readable medium(s) and having computer readable program code embodied thereon that is executable by a computer. A computer readable storage medium as used herein is considered a non-transitory storage medium given the inherent capability to store the information therein as well as the inherent capability to provide retrieval of the information there from. A computer readable storage medium can be, for example, but is not limited to, an electronic, magnetic, optical, electromagnetic, infrared, or semiconductor system, apparatus, or device, or any suitable combination of the foregoing. It is to be appreciated that the following, while providing more specific examples of computer readable storage mediums to which the present principles can be applied, is merely an illustrative and not exhaustive listing, as is readily appreciated by one of ordinary skill in the art: a hard disk, a read-only memory (ROM), an erasable programmable read-only memory (EPROM or Flash memory), a portable compact disc read-only memory (CD-ROM), an optical storage device, a magnetic storage device, or any suitable combination of the foregoing.

## Claims

1. A method for evaluating performance of a storage device (12) connected to a host device (11), wherein the method is implemented by said host device, the method comprising:
executing (402) read-write tests on said storage device, wherein said read-write tests comprise binary read-write operations on a memory segment in said storage device and evaluation of a time required to complete said binary read-write operations;
evaluating (403) a performance profile of said storage device through measuring a read-write transfer bit rate of said storage device according to a result of said read-write tests and through a classification in a plurality of predetermined classes, said performance profile indicating and enabling to determine whether said storage device has sufficient performance capabilities to be used as a device for storing and retrieving video data with a video resolution out of a plurality of predetermined video resolutions; and
showing a message destined to a user of the host device, said message indicating the performance profile as evaluated for the storage device.

2. The method according to claim 1, wherein contents of said memory segment are saved in said host device before executing said read-write tests and said saved contents are restored to said storage device after having executed said read-write tests.

3. The method according to any of claims 1 to 2, wherein said evaluating of said performance profile further comprises obtaining a maximum number of supported simultaneous read-write operations.

4. The method according to any of claims 1 to 3, wherein said video resolution is one of a standard definition video resolution, a high definition video resolution, or an ultra-high definition video resolution.

5. The method according to claim 3, wherein said performance profile further indicates a personal video recording type class, obtained from said maximum number of supported simultaneous read-write operations, said personal video recording type class being one of:
a recording or time shift class;
a recording and time shift class.

6. The method according to any of claims 1 to 5, wherein said performance profile is saved in said host device.

7. The method according to any of claims 1 to 6, wherein said performance profile is saved in a network storage area.

8. A host device (11) for evaluating performance of a storage device (12) connected to said host device, comprising a processor (116) and memory (110, 111) configured to:
execute read-write tests on said storage device, wherein said read-write tests comprise binary read-write operations on a memory segment in said storage device and evaluation of a time required to complete said binary read-write operations;
evaluate a performance profile of said storage device through measuring a read-write transfer bit rate of said storage device according to a result of said read-write tests and through a classification in a plurality of predetermined classes, said performance profile indicating and enabling to determine whether said storage device has sufficient performance capabilities to be used as a device for storing and retrieving video data with a video resolution out of a plurality of predetermined video resolutions; and
show a message destined to a user of the host device, said message indicating the performance profile as evaluated for the storage device.

9. The host device according to claim 8, wherein said processor and said memory are further configured to save contents of said memory segment in said host device before executing said read-write tests and to restore said saved contents to said storage device after having executed said read-write tests.

10. The host device according to any of claims 8 to 9, wherein said processor and said memory are further configured to obtain a maximum number of supported simultaneous read-write operations in order to evaluate said performance profile.

11. The host device according to any of claims 8 to 10, wherein said processor and said memory are further configured to save said performance profile in said host device.

12. The host device according to any of claims 8 to 11, wherein said processor and said memory are further configured to save said performance profile in a network storage area.

## Patentansprüche

1. Verfahren zum Bewerten der Leistung einer Ablagespeichervorrichtung (12), die mit einer Host-Vorrichtung (11) verbunden ist, wobei das Verfahren durch die Host-Vorrichtung implementiert wird, wobei das Verfahren umfasst:
Ausführen (402) von Lese-Schreib-Tests an der Ablagespeichervorrichtung, wobei die Lese-Schreib-Tests binäre Lese-Schreib-Operationen an einem Speichersegment in der Ablagespeichervorrichtung und die Bewertung einer Zeitdauer, die zum Abschließen der binären Lese-Schreib-Operationen erforderlich ist, umfassen;
Bewerten (403) eines Leistungsprofils der Ablagespeichervorrichtung durch Messen einer Lese-Schreib-Übertragungsbitrate der Ablagespeichervorrichtung gemäß einem Ergebnis der Lese-Schreib-Tests und durch eine Klassifizierung in mehrere vorgegebene Klassen, wobei das Leistungsprofil angibt und zu bestimmen ermöglicht, ob die Ablagespeichervorrichtung ausreichende Leistungsfähigkeiten aufweist, um als eine Vorrichtung zum Speichern und Auslesen von Videodaten mit einer Videoauflösung aus mehreren vorgegebenen Videoauflösungen verwendet zu werden; und
Zeigen einer Nachricht, die für einen Benutzer der Host-Vorrichtung bestimmt ist, wobei die Nachricht das Leistungsprofil angibt, wie es für die Ablagespeichervorrichtung bewertet worden ist.

2. Verfahren nach Anspruch 1, wobei der Inhalt des Speichersegments in der Host-Vorrichtung gesichert wird, bevor die Lese-Schreib-Tests ausgeführt werden, und der gesicherte Inhalt in der Ablagespeichervorrichtung wiederhergestellt wird, nachdem die Lese-Schreib-Tests ausgeführt worden sind.

3. Verfahren nach einem der Ansprüche 1 bis 2, wobei das Bewerten des Leistungsprofils ferner das Erhalten einer maximalen Anzahl unterstützter gleichzeitiger Lese-Schreib-Operationen umfasst.

4. Verfahren nach einem der Ansprüche 1 bis 3, wobei die Videoauflösung eine Standardvideoauflösung oder eine hochauflösende Videoauflösung oder eine ultrahochauflösende Videoauflösung ist.

5. Verfahren nach Anspruch 3, wobei das Leistungsprofil ferner eine Klasse des persönlichen Videoaufzeichnungstyps angibt, die aus der maximalen Anzahl unterstützter gleichzeitiger Lese-Schreib-Operationen erhalten wird, wobei die Klasse des persönlichen Videoaufzeichnungstyps eine der folgenden ist:
eine Aufzeichnungs- oder Zeitverschiebungsklasse;
eine Aufzeichnungs- und Zeitverschiebungsklasse.

6. Verfahren nach einem der Ansprüche 1 bis 5, wobei das Leistungsprofil in der Host-Vorrichtung gesichert wird.

7. Verfahren nach einem der Ansprüche 1 bis 6, wobei das Leistungsprofil in einem Netzablagespeicherbereich gesichert wird.

8. Host-Vorrichtung (11) zum Bewerten der Leistung einer Ablagespeichervorrichtung (12), die mit der Host-Vorrichtung verbunden ist, wobei die Host-Vorrichtung einen Prozessor (116) und einen Speicher (110, 111) umfasst, wobei die Host-Vorrichtung konfiguriert ist zum:
Ausführen von Lese-Schreib-Tests an der Ablagespeichervorrichtung, wobei die Lese-Schreib-Tests binäre Lese-Schreib-Operationen an einem Speichersegment in der Ablagespeichervorrichtung und die Bewertung einer Zeitdauer,
die zum Abschließen der binären Lese-Schreib-Operationen erforderlich ist, umfassen;
Bewerten eines Leistungsprofils der Ablagespeichervorrichtung durch Messen einer Lese-Schreib-Übertragungsbitrate der Ablagespeichervorrichtung gemäß einem Ergebnis der Lese-Schreib-Tests und durch eine Klassifizierung in mehrere vorgegebene Klassen, wobei das Leistungsprofil angibt und zu bestimmen ermöglicht, ob die Ablagespeichervorrichtung ausreichende Leistungsfähigkeiten aufweist, um als eine Vorrichtung zum Speichern und Auslesen von Videodaten mit einer Videoauflösung aus mehreren vorgegebenen Videoauflösungen verwendet zu werden; und
Zeigen einer Nachricht, die für einen Benutzer der Host-Vorrichtung bestimmt ist, wobei die Nachricht das Leistungsprofil angibt, wie es für die Ablagespeichervorrichtung bewertet worden ist.

9. Host-Vorrichtung nach Anspruch 8, wobei der Prozessor und der Speicher ferner dafür konfiguriert sind, den Inhalt des Speichersegments in der Host-Vorrichtung zu sichern, bevor die Lese-Schreib-Tests ausgeführt werden, und den gesicherten Inhalt in der Ablagespeichervorrichtung wiederherzustellen, nachdem die Lese-Schreib-Tests ausgeführt worden sind.

10. Host-Vorrichtung nach einem der Ansprüche 8 bis 9, wobei der Prozessor und der Speicher ferner dafür konfiguriert sind, eine maximale Anzahl unterstützter gleichzeitiger Lese-Schreib-Operationen zu erhalten, um das Leistungsprofil zu bewerten.

11. Host-Vorrichtung nach einem der Ansprüche 8 bis 10, wobei der Prozessor und der Speicher ferner dafür konfiguriert sind, das Leistungsprofil in der Host-Vorrichtung zu sichern.

12. Host-Vorrichtung nach einem der Ansprüche 8 bis 11, wobei der Prozessor und der Speicher ferner dafür konfiguriert sind, dass Leistungsprofil in einem Netzablagespeicherbereich zu sichern.

## Revendications

1. Procédé pour évaluer la performance d'un dispositif de stockage (12) connecté à un dispositif hôte (11), dans lequel le procédé est mis en oeuvre par ledit dispositif hôte, le procédé comprenant :
l'exécution (402) de tests de lecture-écriture sur ledit dispositif de stockage, où lesdits tests de lecture-écriture comprennent des opérations de lecture-écriture binaires sur un segment de mémoire dans ledit dispositif de stockage et l'évaluation d'un temps requis pour effectuer lesdites opérations de lecture-écriture binaires ;
l'évaluation (403) d'un profil de performance dudit dispositif de stockage par la mesure d'un débit binaire de transfert de lecture-écriture dudit dispositif de stockage selon un résultat desdits tests de lecture-écriture et par une classification dans une pluralité de classes prédéterminées, ledit profil de performance indiquant et permettant de déterminer si ledit dispositif de stockage a des capacités de performance suffisantes pour être utilisé comme un dispositif pour stocker et récupérer des données vidéo avec une résolution vidéo parmi une pluralité de résolutions vidéo prédéterminées ; et
l'affichage d'un message destiné à un utilisateur du dispositif hôte, ledit message indiquant le profil de performance évalué pour le dispositif de stockage.

2. Procédé selon la revendication 1, dans lequel le contenu dudit segment de mémoire est enregistré dans ledit dispositif hôte avant l'exécution desdits tests de lecture-écriture et ledit contenu enregistré est restauré sur ledit dispositif de stockage après l'exécution desdits tests de lecture-écriture.

3. Procédé selon l'une quelconque des revendications 1 à 2, dans lequel ladite évaluation dudit profil de performance comprend en outre l'obtention d'un nombre maximal d'opérations de lecture-écriture simultanées prises en charge.

4. Procédé selon l'une quelconque des revendications 1 à 3, dans lequel ladite résolution vidéo est l'une d'une résolution vidéo de définition standard, d'une résolution vidéo haute définition ou d'une résolution vidéo ultra-haute définition.

5. Procédé selon la revendication 3, dans lequel ledit profil de performance indique en outre une classe de type d'enregistrement vidéo personnel, obtenue à partir dudit nombre maximal d'opérations de lecture-écriture simultanées prises en charge, ladite classe de type d'enregistrement vidéo personnel étant l'une des suivantes :
classe d'enregistrement ou de décalage temporel;
classe d'enregistrement et de décalage temporel.

6. Procédé selon l'une quelconque des revendications 1 à 5, dans lequel ledit profil de performance est enregistré dans ledit dispositif hôte.

7. Procédé selon l'une quelconque des revendications 1 à 6, dans lequel ledit profil de performance est enregistré dans un espace de stockage réseau.

8. Dispositif hôte (11) pour évaluer la performance d'un dispositif de stockage (12) connecté audit dispositif hôte, comprenant un processeur (116) et une mémoire (110, 111) configurés pour :
exécuter des tests de lecture-écriture sur ledit dispositif de stockage, où lesdits tests de lecture-écriture comprennent des opérations de lecture-écriture binaires sur un segment de mémoire dans ledit dispositif de stockage et l'évaluation d'un temps requis pour effectuer lesdites opérations de lecture-écriture binaires ;
évaluer un profil de performance dudit dispositif de stockage par la mesure d'un débit binaire de transfert de lecture-écriture dudit dispositif de stockage selon un résultat desdits tests de lecture-écriture et par une classification dans une pluralité de classes prédéterminées, ledit profil de performance indiquant et permettant de déterminer si ledit dispositif de stockage a des capacités de performance suffisantes pour être utilisé comme un dispositif pour stocker et récupérer des données vidéo avec une résolution vidéo parmi une pluralité de résolutions vidéo prédéterminées ; et
afficher un message destiné à un utilisateur du dispositif hôte, ledit message indiquant le profil de performance évalué pour le dispositif de stockage.

9. Dispositif hôte selon la revendication 8, dans lequel ledit processeur et ladite mémoire sont en outre configurés pour enregistrer le contenu dudit segment de mémoire dans ledit dispositif hôte avant l'exécution desdits tests de lecture-écriture et pour restaurer ledit contenu enregistré sur ledit dispositif de stockage après l'exécution desdits tests de lecture-écriture.

10. Dispositif hôte selon l'une quelconque des revendications 8 à 9, dans lequel ledit processeur et ladite mémoire sont en outre configurés pour obtenir un nombre maximal d'opérations de lecture-écriture simultanées prises en charge pour évaluer ledit profil de performance.

11. Dispositif hôte selon l'une quelconque des revendications 8 à 10, dans lequel ledit processeur et ladite mémoire sont en outre configurés pour enregistrer ledit profil de performance dans ledit dispositif hôte.

12. Dispositif hôte selon l'une quelconque des revendications 8 à 11, dans lequel ledit processeur et ladite mémoire sont en outre configurés pour enregistrer ledit profil de performance dans un espace de stockage réseau.
